Europäisches Patentamt

European Patent Office

Office européen des brevets

(19)

(11) Veröffentlichungsnummer : **0 400 373 B1**

# (12) EUROPÄISCHE PATENTSCHRIFT

(45) Veröffentlichungstag der Patentschrift :
17.05.95 Patentblatt 95/20

(51) Int. Cl.⁶ : **G01R 31/26, G01R 31/308**

(21) Anmeldenummer : **90108837.7**

(22) Anmeldetag : **10.05.90**

(54) **Verfahren zur ortsaufgelösten Bestimmung der Diffusionslänge von Minoritätsladungsträgern in einem Halbleiterkristallkörper mit Hilfe einer elektrolytischen Zelle.**

(30) Priorität : **31.05.89 DE 3917702**

(43) Veröffentlichungstag der Anmeldung :
**05.12.90 Patentblatt 90/49**

(45) Bekanntmachung des Hinweises auf die
Patenterteilung :
**17.05.95 Patentblatt 95/20**

(84) Benannte Vertragsstaaten :
**DE FR GB IT NL**

(56) Entgegenhaltungen :
**EP-A- 0 295 440**
**EP-A- 0 310 082**

(56) Entgegenhaltungen :
**JOURNAL OF THE ELECTROCHEMICAL SO-
CIETY Band 129, Nr. 6, Juni 1982, Seiten
1237-1240, Manchester, New Hampshire, GB;
L. DE ANGELIS et al.: "LocalSpectral Responses of Transition Metal Dichalcogenides in
PhotoelectrochemicalCells"**
**IBM TECHNICAL DISCLOSURE BULLETIN
Band 18, Nr. 11, April 1976, Seiten 3623,3624,
New York, NY, US; G. MARKOVITS et al.:
"Scanning CathodicCurrent Spectroscopy"**

(73) Patentinhaber : SIEMENS
AKTIENGESELLSCHAFT
Wittelsbacherplatz 2
D-80333 München (DE)

(72) Erfinder : Föll, Helmut, Dr.
Wemdinger Strasse 40
D-8000 München 80 (DE)
Erfinder : Lehmann, Volker, Dr.
Neumarkter Strasse 82a
D-8000 München 80 (DE)

EP 0 400 373 B1

**Beschreibung**

Verfahren zur ortsaufgelösten Bestimmung der Diffusionslänge von Minoritätsladungsträgern in einem Halbleiterkristallkörper mit Hilfe einer elektrolytischen Zelle

Die Erfindung betrifft ein Verfahren zur ortsaufgelösten Bestimmung der Diffusionslänge der Minoritätsladungsträger in einem Halbleiterkristallkörper nach dem Oberbegriff des Patentanspruchs 1, mit welchem Defekte und Verunreinigungen zerstörungsfrei detektiert werden können. Ein derartiges Verfahren ist aus dem Artikel von L. de Angelis et al. in J. Electrochem. Soc., Vol. 129 (1982) June, No.6, Seiten 1237-1240 bekannt. Details der Bestimmung der Diffusionslänge gehen aus dem Artikel, der primär die Spektralverteilung des Photostroms in Abhängigkeit vom Wellenlängenspektrum diskutiert, jedoch nicht hervor.

Verunreinigungen und Defekte in einem Halbleiterkristallkörper (sog. Wafer) stellen Rekombinationszentren für Minoritätsladungsträger dar. Die Diffusionslänge L von Minoritätsladungsträgern ist somit ein Maß für die Dichte von Defekten im Wafer.

Ein weiteres Verfahren zur ortsaufgelösten Bestimmung von L ist aus EP-A-02 95 440 bekannt. Dabei werden Vorder- und Rückseite des Wafers mit je einer elektrolytgefüllten Meßhalbkammer in Kontakt gebracht. Auf der Waferrückseite wird mit Hilfe einer angeschlossenen Gleichspannungsquelle eine sperrende Raumladungszone erzeugt; der andere Pol der Spannungsquelle wird mit einer Elektrode verbunden, die sich im Elektrolyt der rückseitigen Meßhalbzelle befindet. Die Wafervorderseite wird mit sichtbarem Licht, z. B. eines He-Ne-Lasers, bestrahlt. Der Photostrom der erzeugten Minoritätsladungsträger wird an der Waferrückseite detektiert und auf den an der vorderseitigen Waferoberfläche gemessenen normiert. Aus diesem Quotienten wird die Diffusionslänge L mathematisch bestimmt.

Das Verfahren ist jedoch nur dann anwendbar, wenn die Diffusionslänge L größer ist als etwa 1/4 der Waferdicke D, da sonst zu wenig Minoritätsladungsträger bis zur Waferrückseite diffundieren. Aufgabe ist es, die quantitative und ortsaufgelöste Bestimmung der Diffusionslänge auch für L < 1/4 D zu ermöglichen.

Diese Aufgabe wird bei einem Verfahren der eingangs genannten Art erfindungsgemäß dadurch gelöst, daß die Diffusionslänge L mit Hilfe der mathematischen Gleichung

$$\frac{I_1}{I_{1,\,max}} = \frac{\alpha\,L}{1 + \alpha\,L}\,e^{-\,\alpha.w}$$

mit

$\alpha$ = Absorptionskoeffizient für Strahlung der Wellenlänge

$w$ = Ausdehnung der Raumladungszone

bestimmt wird, wobei $I_{1,\,max}$ durch Eichung mit Hilfe einer

Probe mit bekannter, sehr großer Diffusionslänge ermittelt wird.

Weiterbildungen der Erfindung sind Gegenstand von Unteransprüchen. Die Erfindung wird nachfolgend anhand von Ausführungsbeispielen näher erläutert, die in den Zeichnungen dargestellt sind.

FIG 1      zeigt schematisch die verwendete Meßvorrichtung;

FIG 2      zeigt die Abhängigkeit des gemessenen Vorderseiten-Fotostroms $I_1$ von der Diffusionslänge L in schematischer Darstellung;

FIG 3      zeigt die Ortsverteilung der Diffusionslänge über einen gezielt in der Mittellinie verunreinigten Wafer

        a) ermittelt mit dem erfindungsgemäßen Meßverfahren

        b) ermittelt mit dem Meßverfahren gemäß EP-A-02 95 440.

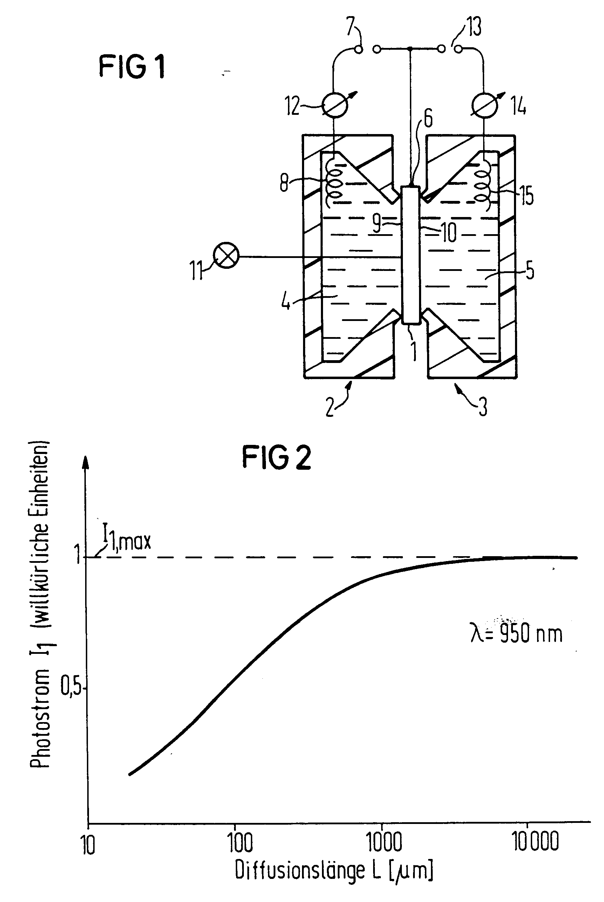

Gemäß FIG 1 befindet sich ein Wafer 1 zwischen zwei mit Elektrolyt 4, 5 gefüllten Meßhalbkammern 2, 3. Als Elektrolyt kann z.B. 2 %ige Flußsäure mit Zusatz eines Netzmittels verwendet werden. Der Wafer 1 ist über einen ohmschen Kontakt 6 mit einer Spannungsquelle 7 verbunden; der andere Pol der Spannungsquelle ist an eine Elektrode 8 angeschlossen, die sich im Elektrolyt 4 der vorderseitigen Meßhalbkammer 2 befindet. An der Spannungsquelle 7 wird eine Spannung $U_1$ derart eingestellt, daß sich an der Wafervorderseite 9 eine sperrende Raumladungszone bildet. Besteht die Halbleiterscheibe 1 beispielsweise aus p-Si, so wird sie negativ vorgespannt, $U_1$ beträgt etwa 5V.

Die Vorderseite 9 des Wafers wird mit einer Lichtquelle 11 beleuchtet, wobei der Lichtfleck auf etwa 1 mm² fokussiert wird und die Scheibenoberfläche abrastern kann. Lehre der Erfindung ist es, eine Lichtquelle mit einer festen Wellenlänge $\lambda > 800$ nm zu verwenden, da dann Elektronen-Loch-Paare nicht nur an der Scheibenoberfläche, sondern auch tiefer in der Probe erzeugt werden.

Der Fotostrom $I_1$ der Minoritätsladungsträger wird mit einem Ampèremesser 12 gemessen, er ist unter den gegebenen Voraussetzungen eine bekannte Funktion der Zahl der erzeugten Ladungsträger und der Diffusionslänge L

$$I_1 = \frac{q \cdot \phi \cdot \alpha L}{1 + L} e^{-\alpha W} \qquad \text{für } D \gg L$$

$$I_{1,\,max} = q \cdot \phi$$

dargestellt in FIG 2.

Dabei bedeutet

q   = Elementarladung

$\phi$   = Photonenfluß

$\alpha$   = Absorptionskoeffizient von Strahlung der Wellenlänge $\lambda$ im Halbleiter

L   = Diffusionslänge der Minoritätsladungsträger

W   = Ausdehnung der Raumladungszone

D   = Dicke des Wafers 1.

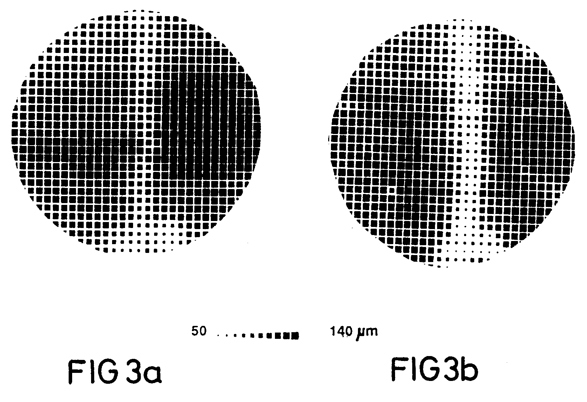

$I_{1,\,max}$ entspricht dem Strom, bei dem alle erzeugten Minoritätsladungsträger erfaßt werden und wird durch Eichung mit Hilfe einer Probe mit bekannter, sehr großer Diffusionslänge ermittelt. FIG 3a zeigt die ortsaufgelöste Messung von L über einen gezielt in der Mittellinie 20 verunreinigten Wafer nach dem erfindungsgemäßen Verfahren, FIG 3b zeigt zum Vergleich das mit dem Meßverfahren gemäß EP-A-02 95 440 erzielte Ergebnis.

Verschiedene Ausführungen des beschriebenen erfindungsgemäßen Verfahrens sind möglich:

1. Geeignete Lichtquellen 11 sind neben konventionellen mit entsprechenden Filtern und Fokussierungsoptiken auch Leuchtdioden, Nd-YAG-Laser und Halbleiterlaser.

2. Die elektrolytgefüllte zweite Meßhalbzelle 3 an der Waferrückseite 10 kann zusätzlich mit einer Spannungsquelle 13 in der Weise beschaltet werden, daß an der Probenrückseite 10 eine sperrende Raumladungszone entsteht. Dann kann ein Rückseitenfotostrom $I_2$ von Minoritätsladungsträgern mit einem Ampèremeter 14 gemessen werden, der gemäß EP-A-02 95 440 ebenfalls zur Bestimmung von L dient.

3. Die elektrolytgefüllte zweite Meßhalbzelle 3 an der Waferrückseite 10 dient zur Erzeugung definierter Verhältnisse, insbesondere Oberflächenzustandsdichte, auf der Probenrückseite 10. Sie ist aber für das erfindungsgemäße Meßprinzip nicht notwendig und kann leer bleiben oder zur Vereinfachung der Meßanordnung weggelassen werden.

## Patentansprüche

1.   Verfahren zur Bestimmung der Diffusionslänge (L) von Minoritätsladungsträgern in einem Halbleiterkristallkörper, bei welchem

i) mindestens eine elektrolytgefüllte Meßhalbkammer (2) an den Halbleiterkristallkörper (1) angebracht wird, so daß seine Vorderseite (9) mit dem Elektrolyt (4) in Kontakt steht,

ii) der Halbleiterkristallkörper (1) über einen ohmschen Kontakt (6) mit einer Spannungsquelle (7) verbunden wird, mit welcher eine Spannung zwischen dem Halbleiterkristallkörper (1) und einer sich im Elektrolyt (4) befindlichen Elektrode (8) angelegt wird,

iii) die Vorderseite (9) des Halbleiterkristallkörpers (1) mit Licht einer Lichtquelle (11) bestrahlt wird,

iv) mittels der angelegten Spannung auf der Vorderseite (9) des Halbleiterkristallkörpers (1) eine sperrende Raumladungszone erzeugt wird,

v) für die Bestrahlung eine Lichtquelle (11) mit einer Wellenlänge $\lambda > 800$ nm verwendet wird,

vi) der Fotostrom ($I_1$) der Minoritätsladungsträger auf der Vorderseite (9) gemessen wird, **dadurch gekennzeichnet**, daß

vii) die Diffusionslänge (L) mit Hilfe der mathematischen Gleichung

$$\frac{I_1}{I_{1,\,max}} = \frac{\alpha L}{1 + \alpha L} e^{-\alpha w}$$

mit

$\alpha$       = Absorptionskoeffizient für Strahlung der Wellenlänge $\lambda$

w       = Ausdehnung der sperrenden Raumladungszone

bestimmt wird, wobei $I_{1,\,max}$ durch Eichung mit Hilfe einer Probe mit bekannter, sehr großer Diffusionslänge ermittelt wird.

2.   Verfahren nach Anspruch 1

**dadurch gekennzeichnet**, daß eine elektrolytgefüllte Meßhalbkammer (2) an der Vorderseite (9) des Halbleiterkristallkörpers (1) verwendet wird.

3.   Verfahren nach Anspruch 1,

**dadurch gekennzeichnet**, daß an der Vorder- und Rückseite (9, 10) des Halbleiterkristallkörpers (1) je eine Meßhalbkammer (2, 3) angebracht wird, wobei mindestens die vorderseitige Meßhalbkammer (2) elektrolytgefüllt ist.

4. Verfahren nach Anspruch 1 und 3,
**dadurch gekennzeichnet**, daß beide Meßhalbkammern (2, 3) elektrolytgefüllt sind, so daß Vorder- und Rückseite (9, 10) des Halbleiterkristallkörpers (1) jeweils mit dem Elektrolyten (4, 5) einer Meßhalbkammer (2, 3) in Kontakt stehen.

5. Verfahren nach einem der Ansprüche 1 bis 4,
**dadurch gekennzeichnet**, daß der Lichtstrahl auf die Vorderseite (9) des Halbleiterkristallkörpers (1) fokussiert wird und diese abrastert, so daß eine ortsaufgelöste Bestimmung erfolgt.

6. Verfahren nach einem der Ansprüche 1 bis 5,
**dadurch gekennzeichnet**, daß als Lichtquelle (11) ein Laser verwendet wird.

7. Verfahren nach einem der Ansprüche 1 bis 5,
**dadurch gekennzeichnet**, daß als Lichtquelle (11) eine Leuchtdiode verwendet wird.

8. Verfahren nach einem der Ansprüche 3 bis 7,
**dadurch gekennzeichnet**, daß eine Sperrspannung ($U_2$) zwischen der Rückseite (10) des Halbleiterkristallkörpers (1) und einer in der rückseitigen Meßhalbkammer (3) befindlichen Elektrode (15) angelegt wird und der Rückseitenfotostrom ($I_2$) der Minoritätsladungsträger zusätzlich gemessen wird.

## Claims

1. Method for determining the diffusion length (L) of minority charge carriers in a semiconductor crystal body, in the case of which
   i) at least one electrolyte-filled measurement half chamber (2) is fitted to the semiconductor crystal body (1) so that its front side (9) is in contact with the electrolyte (4),
   ii) the semiconductor crystal body (1) is connected via a resistive contact (6) to a voltage source (7) by means of which a voltage is applied between the semiconductor crystal body (1) and an electrode (8) which is located in the electrolyte (4),
   iii) the front side (9) of the semiconductor crystal body (1) is illuminated with light from a light source (11),
   iv) a depletion-charge zone is produced by means of the applied voltage on the front side (9) of the semiconductor crystal body (1),
   v) a light source (11) having a wavelength $\lambda > 800$ nm is used for the illumination
   vi) the photocurrent ($I_1$) of the minority charge carriers is measured on the front side (9),
   characterized in that
   vii) the diffusion length (L) is determined with the aid of the mathematical equation

$$\frac{I_1}{I_{1,\,max}} = \frac{\alpha L}{1 + \alpha L}\, e^{-\,\alpha w}$$

   where
   $\alpha$      = absorption coefficient for radiation at the wavelength $\lambda$
   w      = extent of the depletion-charge zone,
   $I_{1,\,max}$ being determined by calibration with the aid of a sample having a known, very large diffusion length.

2. Method according to Claim 1, characterized in that an electrolyte-filled measurement half chamber (2) is used on the front side (9) of the semiconductor crystal body (1).

3. Method according to Claim 1, characterized in that a measurement half chamber (2, 3) is in each case fitted to the front side and rear side (9, 10) of the semiconductor crystal body (1), at least the front-side measurement half chamber (2) being electrolyte-filled.

4. Method according to Claims 1 and 3, characterized in that both measurement half chambers (2, 3) are electrolyte-filled, so that the front side and rear side (9, 10) of the semiconductor crystal body (1) are each in contact with the electrolyte (4, 5) in one measurement half chamber (2, 3).

5. Method according to one of Claims 1 to 4, characterized in that the light beam is focused onto the front side (9) of the semiconductor crystal body (1) and scans said front side (9) so that a position-resolved determination is carried out.

6. Method according to one of Claims 1 to 5, characterized in that a laser is used as the light source (11).

7. Method according to one of Claims 1 to 5, characterized in that a light-emitting diode is used as the light source (11).

8. Method according to one of Claims 3 to 7, characterized in that a reverse voltage ($U_2$) is applied between the rear side (10) of the semiconductor crystal body (1) and an electrode (15) which is located in the rear-side measurement half chamber (3), and the rear-side photocurrent ($I_2$) of the minority charge carriers is additionally measured.


**Revendications**

1. Procédé pour déterminer la longueur de diffusion (L) de porteurs de charge minoritaires dans un corps cristallin semiconducteur, selon lequel
    i) on place au moins une demi-chambre de mesure (2), remplie par un électrolyte, contre le corps cristallin semiconducteur (1) de manière que sa face avant (9) soit en contact avec l'électrolyte (4),
    ii) on relie le corps cristallin semiconducteur (1), par l'intermédiaire d'un contact ohmique (6), à une source de tension (7), au moyen de laquelle on applique une tension entre le corps cristallin semiconducteur (1) et une électrode (8) située dans l'électrolyte (4),
    iii) on éclaire la face avant (9) du corps cristallin semiconducteur (1) avec la lumière d'une source de lumière (11),
    iv) une zone de charges d'espace réalisant un blocage est produite au moyen de la tension appliquée sur la face avant (9) du corps cristallin semiconducteur (1),
    v) pour l'éclairement, on utilise une source de lumière (11) possédant une longueur d'onde $\lambda > 800$ nm,
    vi) on mesure le courant photoélectrique ($I_1$) des porteurs de charge minoritaires sur la face avant (9),
caractérisé par le fait
vii) qu'on détermine la longueur de diffusion (L) à l'aide de la relation mathématique

$$\frac{I_1}{I_{1,max}} = \frac{\alpha L}{1 + \alpha L}\, e^{-\alpha w}$$

avec
$\alpha$      = coefficient d'absorption pour le rayonnement possédant la longueur d'onde $\lambda$,
w      = extension de la zone de charges d'espace réalisant un blocage,
$I_{1,max}$ étant déterminé par étalonnage à l'aide d'un échantillon possédant une longueur de diffusion très grande connue.

2. Procédé suivant la revendication 1, caractérisé par le fait qu'on utilise une demi-chambre de mesure (2) remplie par un électrolyte, sur la face avant (9) du corps cristallin semiconducteur (1).

3. Procédé suivant la revendication 1, caractérisé par le fait qu'on dispose une demi-chambre de mesure (2,3) respectivement sur la face avant et sur la face arrière (9,10) du corps cristallin semiconducteur (1), au moins la demi-chambre de mesure (2) située sur la face avant, étant remplie par un électrolyte.

4. Procédé suivant les revendications 1 et 3, caractérisé par le fait qu'on remplit avec un électrolyte les deux demi-chambres de mesure (2,3), de sorte que la face avant et la face arrière (9,10) du corps cristallin semiconducteur (9) sont respectivement en contact avec l'électrolyte (4,5) d'une demi-chambre de mesure (2,3).

5. Procédé suivant l'une des revendications 1 à 4, caractérisé par le fait qu'on focalise le faisceau de lumière sur la face avant (9) du corps cristallin semiconducteur (1) et qu'on explore cette face par balayage de manière à obtenir une détermination à résolution locale.

6. Procédé suivant l'une des revendications 1 à 5, caractérisé par le fait qu'on utilise un laser comme source de lumière (11).

7. Procédé suivant l'une des revendications 1 à 5, caractérisé par le fait qu'on utilise une diode à luminescence comme source de lumière (11).

8. Procédé suivant l'une des revendications 3 à 7, caractérisé par le fait qu'on applique une tension de blocage ($U_2$) entre la face arrière (10) du corps cristallin semiconducteur (1) et une électrode (15) située dans la demi-chambre de mesure arrière (3) et qu'on mesure en outre le courant photoélectrique ($I_2$) des porteurs de charge minoritaires au niveau de la face arrière.

FIG 1

FIG 2

7

50 ·······■■■ 140 μm

FIG 3a                    FIG 3b